# EUROPEAN PATENT APPLICATION

(11) **EP 4 766 090 A1**
(43) Date of publication of application: **24.06.2026**
(21) Application number: 25208501.4
(22) Date of filing: 14.10.2025
(51) Int. Cl.: H10D 86/40, H10D 86/60

(54) **DISPLAY APPARATUS AND MANUFACTURING METHOD THE SAME**

(30) Priority: 23.12.2024 KR 20240193622
(71) Applicant: LG Display Co., Ltd., Seoul, 07336 (KR)
(72) Inventor: CHOI, SunYoung, Paju-si, Gyeonggi-do 10845 (KR); SHIN, Dongchae, Paju-si, Gyeonggi-do 10845 (KR); JEONG, Mijin, Paju-si, Gyeonggi-do 10845 (KR)
(74) Representative: Viering, Jentschura & Partner mbB Patent- und Rechtsanwälte

(57) **Abstract**

An embodiment of the present disclosure provides a display apparatus (100, 200) comprising a plurality of first thin film transistors (TR1), a plurality of second thin film transistors (TR2), and a plurality of third thin film transistors (TR3) on a substrate (101), wherein each first thin film transistor includes a first active layer (A1) and a first gate electrode (G1) on the first active layer (A1), wherein each second thin film transistor (TR2) includes a second active layer (A2) and a second gate electrode (G2) on the second active layer (A2), wherein each third thin film transistor (TR3) includes a third active layer (A3) and a third gate electrode (G3) on the third active layer (A3), wherein a distance between the second active layer (A2) and the second gate electrode (G2) is greater than a distance between the third active layer (A3) and the third gate electrode (G3), wherein each first thin film transistor (TR1) further includes a first auxiliary electrode (E1) between the substrate (101) and the first active layer (A1), and wherein the first auxiliary electrode (E1) is electrically connected to the first gate electrode (G1). In addition, another embodiment of the present disclosure provides a manufacturing method of the display apparatus (100, 200).

## Description

### BACKGROUND

### Field of Technology

The present disclosure relates to a display apparatus including a thin film transistor and a manufacturing method the same.

### Discussion of the Related Art

Transistors are widely used as switching devices or driving devices in electronic devices. In particular, thin film transistors may be manufactured on glass or plastic substrates, making them widely used as switching elements in display apparatuses such as liquid crystal displays (LCD) and organic light emitting diode displays (OLED).

Thin film transistors may be classified into amorphous silicon thin film transistor in which amorphous silicon is used as the active layer, polycrystalline silicon thin film transistor in which polycrystalline silicon is used as the active layer, and oxide semiconductor thin film transistor in which oxide semiconductor is used as the active layer, based on the material constituting the active layer.

Among these, oxide semiconductor thin film transistors have the advantage of high mobility and can easily obtain desired property because the resistance variation may change depending on the oxygen content. In addition, since the oxide constituting the active layer may be formed at a relatively low temperature during the manufacturing process of oxide semiconductor thin film transistors, the manufacturing cost is low. Since oxide semiconductors are transparent due to the nature of oxides, oxide semiconductor thin film transistors are also advantageous in implementing transparent displays.

Display devices utilize a variety of thin film transistors that perform a variety of functions. For example, TFT used as switching elements in displays requires excellent on-off characteristic, while TFT used as driving elements requires excellent gray scale representation characteristic. However, oxide semiconductor TFTs typically have a low s-factor, making them difficult to use as driving TFTs in display apparatuses for gray scale representation.

In addition, as display apparatuses become higher resolution and larger in size, high mobility materials need to be applied to thin film transistors, and it is necessary to secure the operating reliability of thin film transistors using high mobility material.

### SUMMARY

At least one embodiment of the present disclosure is to provide a display apparatus including a thin film transistor having excellent switching characteristic and a thin film transistor having a large s-factor.

In addition, at least one embodiment of the present disclosure is to provide a display apparatus including a plurality of thin film transistors configured to have different driving characteristic depending on the pixel.

At least one embodiment of the present disclosure is to provide a display apparatus capable of achieving both excellent stability and gray scale expression characteristic by making the active layer compositions of a switching transistor and a driving transistor different.

At least one embodiment of the present disclosure provides a display apparatus designed to enable high-fidelity gradation in the pixels that requires precise gray scale expression by adjusting the distance between an active layer and a gate electrode differently for each pixel.

An embodiment of the present disclosure is intended to provide a manufacturing method for a display apparatus as described above. According to aspects of the present disclosure, a display apparatus and a manufacturing method of a display apparatus according to the independent claims are provided. Further embodiments are described in the dependent claims.

At least one embodiment of the present disclosure for achieving the above described technical subject provides a display apparatus comprising a plurality of first thin film transistors, a plurality of second thin film transistors, and a plurality of third thin film transistors on a substrate, wherein the first thin film transistor includes a first active layer and a first gate electrode on the first active layer, wherein the second thin film transistor includes a second active layer and a second gate electrode on the second active layer, wherein the third thin film transistor includes a third active layer and a third gate electrode on the third active layer, wherein a distance between the second active layer and the second gate electrode is greater than a distance between the third active layer and the third gate electrode, wherein the first thin film transistor further includes a first auxiliary electrode between the substrate and the first active layer, and wherein the first auxiliary electrode is electrically connected to the first gate electrode.

A distance between the first active layer and the first gate electrode may be smaller than the distance between the second active layer and the second gate electrode.

The second active layer and the third active layer may each include a first oxide semiconductor layer and a second oxide semiconductor layer on the first oxide semiconductor layer.

The second oxide semiconductor layer may have a greater mobility than the first oxide semiconductor layer.

The first oxide semiconductor layer may have a mobility of mobility of 14 cm²/V·s or less, and the second oxide semiconductor layer may have a mobility of 15 cm²/V·s or more

The first active layer may be formed of the same material as the first oxide semiconductor layer.

The display apparatus may further include a gate insulating film between the first active layer and the first gate electrode, between the second active layer and the second gate electrode, and between the third active layer and the third gate electrode, wherein a thickness of the gate insulating film between the first active layer and the first gate electrode may be defined as t1, a thickness of the gate insulating film between the second active layer and the second gate electrode may be defined as t2, a thickness of the gate insulating film between the third active layer and the third gate electrode may be defined as t3, and "t2 > t1" and "t2 > t3" may be satisfied.

The display apparatus may further include a buffer layer on the substrate, the buffer layer having a first concave part, and the second active layer may be disposed in the first concave part.

The first concave part may have a flat surface and an inclined surface, and a portion of the second active layer may be disposed on the flat surface, and another portion of the second active layer may be disposed on the inclined surface.

The second active layer may include a first oxide semiconductor layer and a second oxide semiconductor layer on the first oxide semiconductor layer, and at least a portion of the first oxide semiconductor layer may be disposed on the inclined surface.

The display apparatus may further include an insulating layer between the substrate and the buffer layer, and a second auxiliary electrode and a third auxiliary electrode on the insulating layer, wherein the second auxiliary electrode may overlap the second active layer, and the third auxiliary electrode may be spaced apart from the second auxiliary electrode and may overlap the third active layer.

The second auxiliary electrode may have a light shielding property and is electrically connected to the second active layer, and the third auxiliary electrode may have a light shielding property and may be electrically connected to the third active layer.

The insulating layer may have a second concave part, and the second auxiliary electrode may be disposed in the second concave part.

The second concave part may have a flat surface and an inclined surface, and a portion of the second auxiliary electrode may be disposed on the flat surface, and another portion of the second auxiliary electrode may be disposed on the inclined surface.

The first auxiliary electrode may be disposed between the substrate and the insulating layer.

The second thin film transistor may have a greater s-factor than the third thin film transistor.

The display apparatus may include a first pixel and a second pixel on the substrate, wherein the first pixel may include one of the plurality of first thin film transistors, one of the plurality of second thin film transistors, and a first display element connected to the second thin film transistor, and wherein the second pixel may include another one of the plurality of first thin film transistors, one of the plurality of third thin film transistors, and a second display element connected to the third thin film transistor.

The first pixel may emit green light, and the second pixel may emit light of a color other than green.

The display apparatus may further include a gate driver that provides a scan signal to each of the first pixel and the second pixel, and the gate driver may include a buffer transistor that controls application of the scan signal and a switching transistor that controls driving of the buffer transistor, and the switching transistor may include the first thin film transistor.

The buffer transistor may include a fourth auxiliary electrode on the substrate, a fourth active layer on the fourth auxiliary electrode, and a fourth gate electrode on the fourth active layer, the fourth active layer including a first oxide semiconductor layer and a second oxide semiconductor layer on the first oxide semiconductor layer, and the fourth auxiliary electrode may be electrically connected to the fourth gate electrode.

Another embodiment of the present disclosure provides a manufacturing method of a display apparatus that comprises forming a first auxiliary electrode on a substrate, forming a buffer layer on the first auxiliary electrode, forming a first active layer, a second active layer, and a third active layer on the buffer layer, forming a gate insulating film on the first active layer, a second active layer, and a third active layer, and forming a first gate electrode, a second gate electrode, and a third gate electrode on the gate insulating film, wherein forming the buffer layer includes forming a first concave part, wherein the second active layer is formed to be disposed in the first concave part, and wherein the first auxiliary electrode is electrically connected to the first gate electrode.

The manufacturing method may further include, before forming the buffer layer, forming an insulating layer on the substrate and forming a second auxiliary electrode and a third auxiliary electrode on the insulating layer, wherein forming the insulating layer may include forming a second concave part, and the second auxiliary electrode may be formed in the second concave part.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a schematic diagram of a display apparatus according to one embodiment of the present disclosure.
FIG. 2 is a circuit diagram for the pixels of FIG. 1.
FIG. 3 is a cross-sectional view of thin film transistors included in the pixels of FIG. 1.
FIG. 4 is an enlarged cross-sectional view of the first concave part of FIG. 3.
FIG. 5 is a cross-sectional view of thin film transistors included in pixels of a display apparatus according to another embodiment of the present disclosure.
FIG. 6 is an enlarged cross-sectional view of the second concave part of FIG. 5.
FIG. 7 is a schematic circuit diagram of one embodiment of a shift register included in a gate driver.
FIG. 8 is a cross-sectional view of thin film transistors of the gate driver.
FIG. 9A to FIG. 9G are schematic cross-sectional views illustrating a manufacturing process of a display apparatus according to one embodiment of the present disclosure.
FIG. 10A to FIG. 10H are schematic cross-sectional views illustrating a manufacturing process of a display apparatus according to another embodiment of the present disclosure.

### DETAILED DESCRIPTION

The advantages and features of the present disclosure, and the methods for achieving them, will become clearer with reference to the embodiments described in detail below, along with the accompanying drawings. However, the present disclosure is not limited to the embodiments disclosed below, but may be implemented in various different forms. These embodiments are provided solely to ensure that the disclosure of the present disclosure is complete and to inform those skilled in the art of the present disclosure of the invention.

The shapes, sizes, ratios, angles, numbers, or the like. disclosed in the drawings for explaining embodiments of the present disclosure are merely illustrative, and the present disclosure is not limited to the details depicted in the drawings. Throughout the specification, identical components may be designated by identical reference numerals. Furthermore, in describing the present disclosure, if a detailed description of a related known technology is deemed to unnecessarily obscure the gist of the present disclosure, the detailed description will be omitted.

In this specification, when the words "include," "have," and "comprise" are used, other parts may be added, unless the expression "only" is used. When a component is expressed in the singular, the plural is included unless otherwise explicitly stated.

When interpreting a component, it is interpreted as including the error range even if there is no separate explicit description.

When describing a positional relationship, for example, when the positional relationship between two parts is described as 'on top of, 'upper part of, 'lower part of, 'next to', or the like., one or more other parts may be located between the two parts, unless the expression 'right' or 'directly' is used.

Spatially relative terms such as "below," "beneath," "lower," "above," and "upper" may be used to easily describe the relationship of one element or component to another, as illustrated in the drawings. Spatially relative terms should be understood to include different orientations of the elements during use or operation in addition to the orientations depicted in the drawings. For example, if an element depicted in the drawings were flipped over, an element described as "below" or "beneath" another element could end up being placed "above" the other element. Thus, the exemplary term "below" can encompass both the above and below directions. Similarly, the exemplary term "above" or "above" can encompass both the above and below directions.

When describing a temporal relationship, for example, when the temporal relationship is described as 'after', 'following', 'next to', 'before', or the like., it can also include cases where it is not continuous, as long as the expression 'immediately' or 'directly' is not used.

While terms like "first" and "second" are used to describe various components, these components are not limited by these terms. These terms are used merely to distinguish one component from another. Therefore, a "first" component referred to below may also be a "second" component within the technical scope of the present disclosure.

At least one term should be understood to include all possible combinations of one or more associated items. For example, "at least one of the first, second, and third items" may mean not only the first, second, or third items, but also any combination of items that may be represented by two or more of the first, second, and third items.

The features of each of the various embodiments of the present disclosure may be partially or wholly combined or combined with each other, and various technical connections and operations are possible, and each embodiment may be implemented independently of each other or implemented together in a related relationship.

Hereinafter, a display apparatus according to an embodiment of the present disclosure, a manufacturing method thereof, and a display apparatus including the same will be described in detail with reference to the attached drawings. When assigning reference numerals to components in each drawing, identical components may have a same reference numeral as much as possible even though they are shown in different drawings.

In embodiments of the present disclosure, the source electrode and the drain electrode are distinguished only for convenience of explanation, and the source electrode and the drain electrode may be interchanged. In detail, in one embodiment, the source electrode may be the drain electrode, and in one embodiment, the drain electrode may be the source electrode.

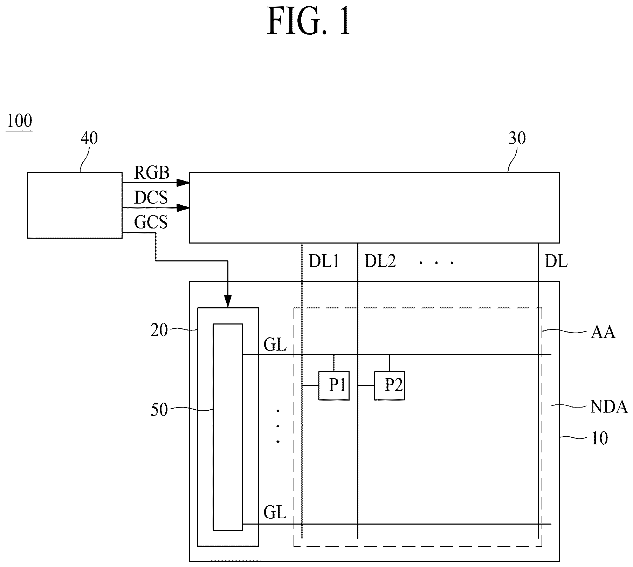

FIG. 1 is a schematic diagram of a display apparatus 100 according to one embodiment of the present disclosure.

A display apparatus 100 according to one embodiment of the present disclosure includes a display panel 10, a gate driver 20, a data driver 30, and a controller 40, as illustrated in FIG. 1.

The display panel 10 may include a display area AA and a non-display area NDA. The pixels P1, P2 are disposed in the display area AA to display an image. A driving unit, wiring, pads, terminals, or the like. may be disposed in the non-display area NDA. No image is displayed in the non-display area NDA.

Gate lines GL and data lines DL1, DL2 are disposed in the display panel 10, and pixels P1, P2 are disposed in the intersection area of the gate lines GL and the data lines DL1, DL2. An image is displayed by driving the pixels P1, P2.

The controller 40 controls the gate driver 20 and the data driver 30.

The controller 40 uses signals supplied from an external system to output a gate control signal GCS for controlling the gate driver 20 and a data control signal DCS for controlling the data driver 30. In addition, the controller 40 samples input image data input from an external system, rearranges it, and supplies the rearranged digital image data RGB to the data driver 30.

The gate control signal GCS includes a gate start pulse GSP, a gate shift clock GSC, a gate output enable signal GOE, a start signal Vst, and a gate clock GCLK. In addition, the gate control signal GCS may include control signals for controlling a shift register 50.

The data control signal DCS includes a source start pulse SSP, a source shift clock signal SSC, a source output enable signal SOE, and a polarity control signal POL.

The data driver 30 supplies data voltage to the data lines DL1, DL2 of the display panel 10. In detail, the data driver 30 converts image data RGB input from the controller 40 into analog data voltage and supplies the data voltage to the data lines DL1, DL2.

The gate driver 20 includes a shift register 50, and the shift register 50 may include a plurality of thin film transistors.

The shift register 50 sequentially supplies gate pulses to the gate lines GL for one frame using a start signal and a gate clock transmitted from the controller 40. Here, one frame refers to a period during which one image is output through the display panel 10. The gate pulse has a turn-on voltage capable of turning on a switching element (thin film transistor) disposed in a pixel P1, P2.

In addition, the shift register 50 supplies a gate-off signal capable of turning off the switching element to the gate line GL during the remaining period during which the gate pulse is not supplied during one frame. Hereinafter, the gate pulse and the gate-off signal are collectively referred to as a scan signal SS or Scan.

According to one embodiment of the present disclosure, the gate driver 20 may be mounted on a substrate 101. As described above, a structure in which the gate driver 20 is directly mounted on the substrate 101 is called a Gate In Panel (GIP) structure. The gate driver 20 may include a plurality of thin film transistors.

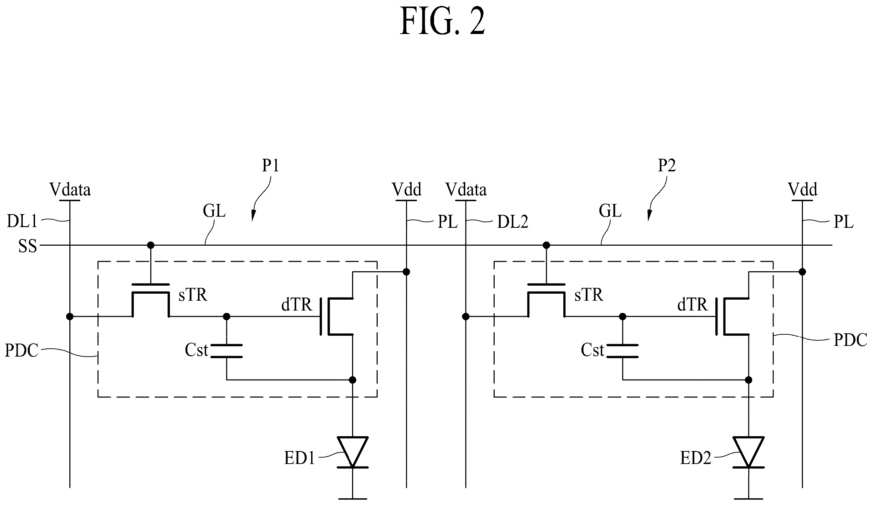

FIG. 2 is a circuit diagram for the pixels P1, P2 of FIG. 1.

The circuit diagram of Fig. 1 is an equivalent circuit diagram for pixels P1, P2 of a display apparatus 10 including organic light emitting diodes (OLED) as display elements ED1, ED2. The display apparatus 10 according to one embodiment of the present disclosure is an organic light emitting display apparatus including organic light emitting diodes (OLED) as display elements ED1, ED2.

Each pixel P1, P2 includes a display element ED1, ED2 and a pixel driving circuit PDC that drives the display element ED1, ED2.

Each pixel driving circuit PDC of FIG. 2 includes a switching transistor sTR and a driving transistor dTR.

The switching transistor sTR is connected to the gate line GL and data lines DL1, DL2, and is turned on or off by a scan signal SS supplied through the gate line GL.

The data lines DL1, DL2 provide data voltage Vdata to the pixel driving circuit PDC, and the switching transistor sTR controls the application of the data voltage Vdata.

The driving power line PL provides a driving voltage Vdd to the display elements ED1, ED2, and the driving transistor dTR controls the driving voltage Vdd. The driving voltage Vdd is a pixel driving voltage for driving the organic light emitting diode (OLED), which is the display element ED1, ED2.

When the switching transistor sTR is turned on by a scan signal SS applied through the gate line GL from the gate driver 20, the data voltage Vdata supplied through the data lines DL1, DL2 is supplied to the gate electrode G2 of the driving transistor dTR connected to the display element ED1, ED2. The data voltage Vdata is charged in the storage capacitor Cst formed between the gate electrode G2 and the source electrode S2 of the driving transistor dTR.

The amount of current supplied to the organic light emitting diode (OLED), which is a display element ED1, ED2, through the driving transistor dTR is controlled according to the data voltage Vdata, and accordingly, the gradation of light output from the display element ED1, ED2 may be controlled.

Although pixels P1, P2 each having two thin film transistors sTR, dTR and one capacitor Cst are illustrated in FIG. 2, one embodiment of the present disclosure is not limited thereto. Each of the pixels P1, P2 may include three or more thin film transistors and two or more capacitors.

A display apparatus 100 according to one embodiment of the present disclosure includes the switching transistor sTR and the driving transistor dTR described above. The switching transistor sTR and the driving transistor dTR may each be made of a thin film transistor.

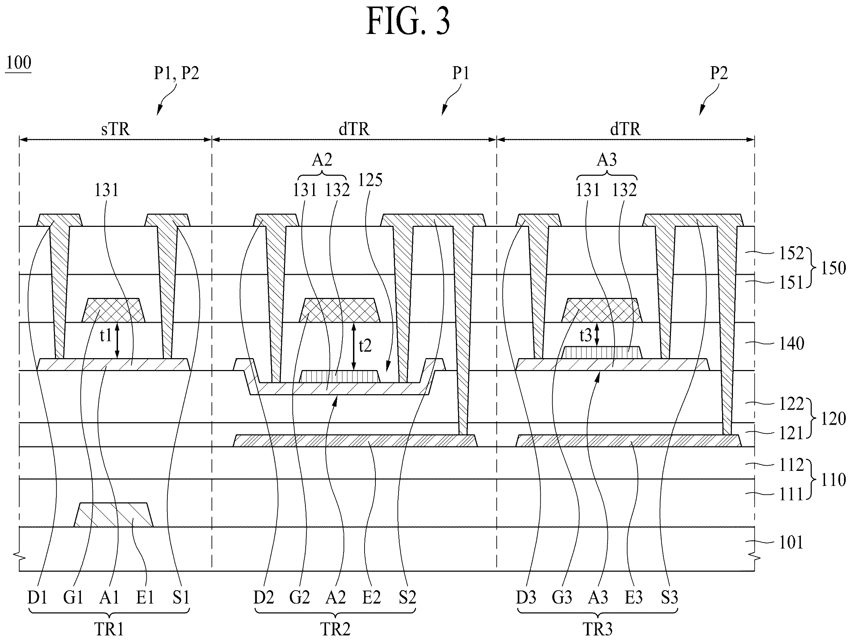

FIG. 3 is a cross-sectional view of thin film transistors included in pixels P1, P2 of FIG. 1.

The switching transistor sTR included in the display apparatus 100 according to one embodiment of the present disclosure may have, for example, the same structure as the first thin film transistor TR1 of FIG. 3. The driving transistor dTR included in the display apparatus 100 according to one embodiment of the present disclosure may have, for example, the same structure as the second thin film transistor TR2 or the third thin film transistor TR3 of FIG. 3.

Referring to FIG. 1 to FIG. 3, a display apparatus 100 according to one embodiment of the present disclosure may include a plurality of first thin film transistors TR1, a plurality of second thin film transistors TR2, and a plurality of third thin film transistors TR3 disposed on a substrate 101.

The first thin film transistor TR1 includes a first active layer A1 and a first gate electrode G1 on the first active layer A1. A second thin film transistor TR includes a second active layer A2 and a second gate electrode G2 on the second active layer A2. A third thin film transistor TR3 includes a third active layer A3 and a third gate electrode G3 on the third active layer. Here, a distance t2 between the second active layer A2 and the second gate electrode G2 is greater than a distance t3 between the third active layer A3 and the third gate electrode G3.

The first thin film transistor TR1 further includes a first auxiliary electrode E1 between the substrate 101 and the first active layer A1, and the first auxiliary electrode E1 may be electrically connected to the first gate electrode G1.

According to one embodiment of the present disclosure, the first thin film transistor TR1 may be used as a switching transistor sTR of the first pixel P1, and the second thin film transistor TR2 may be used as a driving transistor dTR of the first pixel P1. In addition, the first thin film transistor TR1 may be used as a switching transistor sTR of the second pixel P2, and the third thin film transistor TR3 may be used as a driving transistor dTR of the second pixel P2.

Hereinafter, referring to FIG. 3, the configuration of the first thin film transistor TR1, the second thin film transistor TR2, and the third thin film transistor TR3 will be described in detail.

Referring to FIG. 3, a first thin film transistor TR1, a second thin film transistor TR2, and a third thin film transistor TR3 may be disposed on a substrate 101.

The substrate 101 may be made of glass or plastic.

Glass or plastic may be used as the substrate 101. A transparent plastic with flexible property, such as polyimide, may be used as the plastic. When polyimide is used as the substrate 101, considering that a high-temperature deposition process is performed on the substrate 101, a heat-resistant polyimide capable of withstanding high temperatures may be used.

A first auxiliary electrode E1 may be disposed on the substrate 101. The first auxiliary electrode E1 may have electrical conductivity and light shielding property.

The first auxiliary electrode E1 may include at least one of an aluminum based metal such as aluminum (Al) or an aluminum alloy, a silver based metal such as silver (Ag) or a silver alloy, a copper based metal such as copper (Cu) or a copper alloy, a molybdenum based metal such as molybdenum (Mo) or a molybdenum alloy, chromium (Cr), tantalum (Ta), neodymium (Nd), and titanium (Ti). The first auxiliary electrode E1 may also have a multilayer structure including at least two conductive films having different physical properties.

The first auxiliary electrode E1 may be disposed to overlap the first active layer A1. The first auxiliary electrode E1 can protect the first active layer A1 by blocking light incident from the outside.

An insulating layer 110 may be disposed on the first auxiliary electrode E1. The insulating layer 110 is also disposed on the substrate 101. According to one embodiment of the present disclosure, the first auxiliary electrode E1 may be disposed between the substrate 101 and the insulating layer 110.

The insulating layer 110 may include at least one of silicon oxide and silicon nitride. The insulating layer 110 has planarization property and may planarize the upper portion of the substrate 101.

The insulating layer 110 may include, for example, a first insulating layer 111 and a second insulating layer 112 on the first insulating layer 111, as illustrated in FIG. 3. The first insulating layer 111 and the second insulating layer 112 may each include at least one of silicon oxide and silicon nitride. If necessary, the insulating layer 110 can be omitted.

A second auxiliary electrode E2 and a third auxiliary electrode E3 may be disposed on the insulating layer 110. The second auxiliary electrode E2 and the third auxiliary electrode E3 are placed spaced apart from each other.

The second auxiliary electrode E2 overlaps the second active layer A2, and the third auxiliary electrode E3 overlaps the third active layer A3. The second auxiliary electrode E2 and the third auxiliary electrode E3 each have electrical conductivity and may have light shielding property.

The second auxiliary electrode E2 can protect the second active layer A2 by blocking light incident from the outside. In addition, the third auxiliary electrode E3 can protect the third active layer A3 by blocking light incident from the outside.

The second auxiliary electrode E2 and the third auxiliary electrode E3 may each include at least one of an aluminum based metal such as an aluminum alloy, a silver based metal such as silver (Ag) or a silver alloy, a copper based metal such as copper (Cu) or a copper alloy, a molybdenum based metal such as molybdenum (Mo) or a molybdenum alloy, chromium (Cr), tantalum (Ta), neodymium (Nd), and titanium (Ti).

A buffer layer 120 may be disposed on the second auxiliary electrode E2 and the third auxiliary electrode E3. The buffer layer 120 may include at least one of silicon oxide and silicon nitride. The buffer layer 120 protects the active layers A1, A2, A3.

The buffer layer 120 may include, for example, a first buffer layer 121 and a second buffer layer 122 on the first buffer layer 121, as illustrated in FIG. 3. The first buffer layer 121 and the second buffer layer 122 may each include at least one of silicon oxide and silicon nitride.

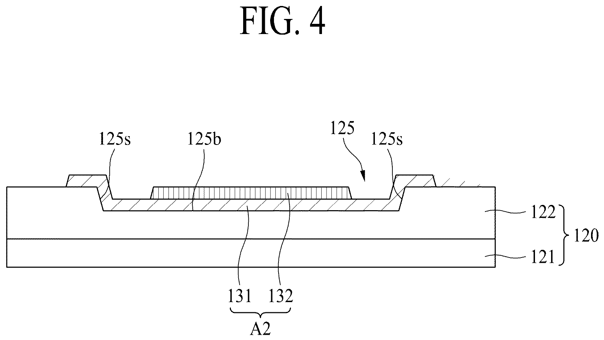

According to one embodiment of the present disclosure, the buffer layer 120 may have a first concave part 125 (see FIG. 4). The first concave part 125 may be formed by removing a portion of the buffer layer 120. The first concave part 125 may overlap the second active layer A2.

The first active layer A1, a second active layer A2, and a third active layer A3 are disposed on the buffer layer 120. The second active layer A2 may be disposed in the first concave part 125 of the buffer layer 120 (see FIG. 4).

According to one embodiment of the present disclosure, the first active layer A1, the second active layer A2, and the third active layer A3 may each include an oxide semiconductor material. For example, the first active layer A1, the second active layer A2, and the third active layer A3 may each include an oxide semiconductor material selected from an IGZO (InGaZnO) based oxide semiconductor material, an IZO (InZnO) based oxide semiconductor material, an ITZO (InSnZnO) based oxide semiconductor material, a FIZO (FeInZnO) based oxide semiconductor material, a ZnO based oxide semiconductor material, a SIZO (SiInZnO) based oxide semiconductor material, a ZnON (Zn-Oxynitride) based oxide semiconductor material, a GZO (GaZnO) based oxide semiconductor material, an IGO (InGaO) based oxide semiconductor material, an IGZTO (InGaZnSnO) based oxide semiconductor material, a GO (GaO) based oxide semiconductor material, a GZTO (GaZnSnO) based oxide semiconductor material, and an IWZO (InWZnO) based oxide semiconductor material.

The first active layer A1 may be disposed to overlap with the first auxiliary electrode E1.

The first active layer A1 may include an oxide semiconductor material having excellent stability and low mobility. For example, the first active layer A1 may have a mobility of 14 cm²/V·s or less.

According to one embodiment of the present disclosure, the first active layer A1 may include at least one of an IGZO (InGaZnO) based oxide semiconductor material, a GZO (GaZnO) based oxide semiconductor material, an IGO (InGaO) based oxide semiconductor material, and a GZTO (GaZnSnO) based oxide semiconductor material. When the oxide semiconductor material constituting the first active layer A1 includes gallium (Ga) and indium (In), the concentration of gallium (Ga) is set higher than the concentration of indium (In) on a mole basis [Ga concentration > In concentration].

Gallium (Ga) is known to form a stable oxygen bond and contributes to film stability. Therefore, a first active layer A1 containing a relatively large amount of gallium (Ga) can have excellent stability. As a result, even though the first thin film transistor TR1, which is used as a switching transistor sTR, has a short channel, the first thin film transistor TR1 can have stable switching characteristic without causing a shift in threshold voltage Vth or a decrease in threshold voltage (Vth roll-off).

According to one embodiment of the present disclosure, the second active layer A2 and the third active layer A3 may each include a first oxide semiconductor layer 131 and a second oxide semiconductor layer 132 on the first oxide semiconductor layer 131. The first oxide semiconductor layer 131 may be disposed on the buffer layer 120.

In the second active layer A2 and the third active layer A3, the second oxide semiconductor layer 132 can have greater mobility than the first oxide semiconductor layer 131. In detail, the first oxide semiconductor layer 131 can have excellent stability, and the second oxide semiconductor layer 132 can have excellent current characteristic.

For example, the first oxide semiconductor layer 131 may have a mobility of 14 cm²/V·s or less. In addition, the second oxide semiconductor layer 132 may have a mobility of 15 cm²/V·s or more. The first oxide semiconductor layer 131 may include a low-mobility oxide semiconductor material, and the second oxide semiconductor layer 132 may include a high-mobility oxide semiconductor material.

According to one embodiment of the present disclosure, the second thin film transistor TR2 and the third thin film transistor TR3 may be used as driving transistors dTR. The driving transistor dTR is used to control the gray scale of the display elements ED1, ED2. For ease of gray scale control, the driving transistor dTR generally has a larger channel length than the switching transistor sTR. However, if the channel length becomes larger, the threshold voltages of the second thin film transistor TR2 and the third thin film transistor TR3, which are driving thin film transistors, may shift in the positive (+) direction. If the shift of the threshold voltage becomes large, it is not easy to control the thin film transistors TR2, TR3, which is not preferable.

Accordingly, according to one embodiment of the present disclosure, the second thin film transistor TR2 and the third thin film transistor TR3, which are driving thin film transistors, are designed to include a second oxide semiconductor layer 132 including a high-mobility oxide semiconductor material. Since the second thin film transistor TR2 and the third thin film transistor TR3 include the second oxide semiconductor layer 132, excessive shift of threshold voltage in the second thin film transistor TR2 and the third thin film transistor TR3 is prevented or suppressed.

Meanwhile, high-mobility oxide semiconductor materials may not have excellent stability. Accordingly, according to one embodiment of the present disclosure, the first oxide semiconductor layer 131 having excellent stability is disposed under the second oxide semiconductor layer 132 including a high-mobility oxide semiconductor material.

The first oxide semiconductor layer 131 has excellent stability, but instead has relatively low mobility. The first oxide semiconductor layer 131 can protect and support the second oxide semiconductor layer 132. Therefore, the first oxide semiconductor layer 131 can also be referred to as a support layer.

According to one embodiment of the present disclosure, the first oxide semiconductor layer 131 may be disposed on the opposite side of the gate electrodes G2, G3 with respect to the second oxide semiconductor layer 132. Referring to FIG. 3, the first oxide semiconductor layer 131 may be disposed between the second oxide semiconductor layer 132 and the substrate 101.

According to one embodiment of the present disclosure, the first oxide semiconductor layer 131 may include at least one of an IGZO (InGaZnO) based oxide semiconductor material, a GZO (GaZnO) based oxide semiconductor material, an IGO (InGaO) based oxide semiconductor material, and a GZTO (GaZnSnO) based oxide semiconductor material. When the oxide semiconductor material constituting the first oxide semiconductor layer 131 includes gallium (Ga) and indium (In), the concentration of gallium (Ga) is set higher than the concentration of indium (In) on a mole basis [Ga concentration > In concentration].

According to one embodiment of the present disclosure, the first active layer A1 may be formed of the same material as the first oxide semiconductor layer 131. For example, the first active layer A1 may be formed of the same material as the first oxide semiconductor layer 131 through the same process.

According to one embodiment of the present disclosure, the second oxide semiconductor layer 132 may include at least one of an IGZO (InGaZnO) based oxide semiconductor material, an IZO (InZnO) based oxide semiconductor material, an IGZTO (InGaZnSnO) based oxide semiconductor material, an ITZO (InSnZnO) based oxide semiconductor material, a FIZO (FeInZnO) based oxide semiconductor material, a ZnO based oxide semiconductor material, an InO based oxide semiconductor material, a TO (SnO) based oxide semiconductor material, an SIZO (SiInZnO) based oxide semiconductor material, and a ZnON (Zn-Oxynitride) based oxide semiconductor material. When the oxide semiconductor material constituting the second oxide semiconductor layer 132 includes indium (In) and gallium (Ga), the concentration of indium (In) is higher than the concentration of gallium (Ga) on an atomic basis [In concentration > Ga concentration].

The second oxide semiconductor layer 132 has high mobility characteristic and can have a mobility of 15 cm²/V·s or more. In addition, the second oxide semiconductor layer 132 may have a mobility of 20 cm²/V·s or more, may have a mobility in the range of 20 to 50 cm²/V·s, may have a mobility in the range of 20 to 40 cm²/V·s, or may have a mobility in the range of 20 to 30 cm²/V·s.

According to one embodiment of the present disclosure, the second active layer A2 may be disposed in the first concave part 125 formed in the buffer layer 120.

FIG. 4 is an enlarged cross-sectional view of the first concave part 125 of FIG. 3.

Referring to FIG. 3 and FIG. 4, the first concave part 125 may have a flat surface 125b and an inclined surface 125s. Referring to the drawings, the flat surface 125b may be, for example, a plane parallel to the substrate 101. The inclined surface 125s may be, for example, a surface inclined at a predetermined angle with respect to the substrate 101.

According to one embodiment of the present disclosure, the flat surface 125b and the inclined surface 125s may be formed in the buffer layer 120. Referring to FIG. 4, the flat surface 125b and the inclined surface 125s may be formed in the second buffer layer 122. It may be said that each of the flat surface 125b and the inclined surface 125s is a surface formed on the buffer layer 120.

A first concave part 125 may be defined by the flat surface 125b and the inclined surface 125s. The first concave part 125 may be an area or space surrounded by the flat surface 125b and the inclined surface 125s.

According to one embodiment of the present disclosure, a part of the second active layer A2 may be disposed on the flat surface 125b, and another part of the second active layer A2 may be disposed on the inclined surface 125s.

In addition, the first oxide semiconductor layer 131 and the second oxide semiconductor layer 132 included in the second active layer A2 may be disposed in the first concave part 125. Referring to FIGS. 3 and 4, a portion of the first oxide semiconductor layer 131 may be disposed on the flat surface 125b. In addition, another portion of the first oxide semiconductor layer 131 may be disposed on the inclined surface 125s.

According to one embodiment of the present disclosure, the second oxide semiconductor layer 132 may be disposed on the flat surface 125b of the first concave part 125. In detail, the second oxide semiconductor layer 132 may be disposed on the first oxide semiconductor layer 131 over the flat surface 125b of the first concave part 125.

The first oxide semiconductor layer 131 disposed on the flat surface 125b and the inclined surface 125s can efficiently support and protect the second oxide semiconductor layer 132. The first oxide semiconductor layer 131 can support the bottom surface of the second oxide semiconductor layer 132 and protect the side surface of the second oxide semiconductor layer 132.

A gate insulating film 140 is disposed on the first active layer A1, the second active layer A2, and the third active layer A3.

The gate insulating film 140 protects the active layers A1, A2, A3 and separates the active layers A1, A2, A3 from the gate electrodes G1, G2, G3. According to one embodiment of the present disclosure, the gate insulating film 140 is disposed at least between the first active layer A1 and the first gate electrode G1, between the second active layer A2 and the second gate electrode G2, and between the third active layer A3 and the third gate electrode G3.

The gate insulating film 140 may have a single-layer film structure or a multi-layer film structure. The gate insulating film 140 may include, for example, at least one of silicon oxide, silicon nitride, and metal oxide.

A first gate electrode A1, a second gate electrode A2, and a third gate electrode A3 are disposed on a gate insulating film 140.

The first gate electrode A1 overlaps at least a portion of the first active layer A1, the second gate electrode A2 overlaps at least a portion of the second active layer A2, and the third gate electrode A3 overlaps at least a portion of the third active layer A3. The region among the active layers A1, A2, A3 overlapping with the gate electrodes G1, G2, G3 may be a channel region.

Each of the first gate electrode A1, the second gate electrode A2, and the third gate electrode A3 may include at least one of an aluminum based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), and titanium (Ti). Each of the first gate electrode A1, the second gate electrode A2, and the third gate electrode A3 may have a multi-layer structure including at least two conductive layers having different physical properties.

According to one embodiment of the present disclosure, as the second active layer A2 is disposed in the first concave part 125, the thickness of the gate insulating film 140 may vary depending on the location. As a result, the distances between the active layers A1, A2, A3 and the gate electrodes G1, G2, G3 may vary depending on the location.

According to one embodiment of the present disclosure, when the thickness of the gate insulating film 140 between the first active layer A1 and the first gate electrode G1 is t1, the thickness of the gate insulating film 140 between the second active layer A2 and the second gate electrode G1 is t2, and the thickness of the gate insulating film 140 between the third active layer A3 and the third gate electrode G1 is t3, "t2 > t1" and "t2 > t3" are satisfied.

An interlayer insulating film 150 is disposed on the first gate electrode A1, the second gate electrode A2, and the third gate electrode A3.

The interlayer insulating film 150 is made of an insulating material. In detail, the interlayer insulating film 150 may be made of an organic material, an inorganic material, or a laminate of an organic layer and an inorganic layer. The interlayer insulating film 150 may include silicon oxide (SiOx) or silicon nitride (SiNx).

Referring to FIG. 3, the interlayer insulating film 150 may include a first insulating film 151 and a second insulating film 152. The first insulating film 151 and the second insulating film 152 may each include at least one of silicon oxide (SiOx) and silicon nitride (SiNx).

The source electrodes S1, S2, S3 and drain electrodes D1, D2, D3 may be disposed on the interlayer insulating film 150.

The source electrodes S1, S2, S3 and the drain electrodes D1, D2, D3 may each include at least one of molybdenum (Mo), aluminum (Al), chromium (Cr), gold (Au), titanium (Ti), nickel (Ni), neodymium (Nd), copper (Cu), and alloys thereof. The source electrodes S1, S2, S3 and the drain electrodes D1, D2, D3 may each be formed as a single layer made of a metal or an alloy of metals, or may be formed as a multi-layer including two or more layers.

The first source electrode S1 and the first drain electrode D1 are spaced apart from each other and are each connected to the first active layer A1. The first source electrode S1 and the first drain electrode D1 may be connected to the first active layer A1 through contact holes formed in the gate insulating film 140 and the interlayer insulating film 150, respectively.

The second source electrode S2 and the second drain electrode D2 are spaced apart from each other and are each connected to the second active layer A2. The second source electrode S2 and the second drain electrode D2 may be connected to the second active layer A2 through contact holes formed in the gate insulating film 140 and the interlayer insulating film 150, respectively.

**In** addition, the second source electrode S2 may be connected to the second auxiliary electrode E2 through a contact hole. As a result, the second auxiliary electrode E2 may be electrically connected to the second active layer A2. In detail, the second auxiliary electrode E2 may be electrically connected to the second active layer A2 through the second source electrode S2.

The third source electrode S3 and the third drain electrode D3 are spaced apart from each other and are each connected to the third active layer A3. The third source electrode S3 and the third drain electrode D3 may be connected to the third active layer A3 through contact holes formed in the gate insulating film 140 and the interlayer insulating film 150, respectively.

In addition, the third source electrode S3 may be connected to the third auxiliary electrode E3 through a contact hole. As a result, the third auxiliary electrode E3 may be electrically connected to the third active layer A3. In detail, the third auxiliary electrode E3 may be electrically connected to the third active layer A3 through the third source electrode S3.

According to one embodiment of the present disclosure, the first thin film transistor TR1 may include a first auxiliary electrode E1, a first active layer A1, a first gate electrode G1, a first source electrode S1, and a first drain electrode D1.

According to one embodiment of the present disclosure, the first gate electrode G1 may be connected to the first auxiliary electrode E1. Accordingly, the same voltage as that of the first gate electrode G1 may be applied to the first auxiliary electrode E1. The first auxiliary electrode E1 overlaps the first active layer A1 and may function as a gate electrode for the first active layer A1. Therefore, according to one embodiment of the present disclosure, the first thin film transistor TR1 may have a double gate structure in which gate electrodes are disposed on both upper side and lower side of the first active layer A1.

In addition, the distance between the first active layer A1 and the first gate electrode G1 may be designed to be smaller than the distance t2 between the second active layer A2 and the second gate electrode G2 of the second thin film transistor TR2. Accordingly, when voltage is applied to the first gate electrode G1, a relatively strong electric field may be applied to the first active layer A1.

The first thin film transistor TR1 having such a structure can have excellent switching characteristic. The first thin film transistor TR1 has a double gate structure and thus has excellent on-off characteristic, and has the first active layer A1 including a stable first oxide semiconductor layer 131 having low mobility, so that the first thin film transistor TR1 can have excellent functional stability.

According to one embodiment of the present disclosure, the second thin film transistor TR2 may include a second auxiliary electrode E2, a second active layer A2, a second gate electrode G2, a second source electrode S2, and a second drain electrode D2.

Since the second auxiliary electrode E2 is connected to the second source electrode S2 and overlaps the second active layer A2, at the time when the second thin film transistor TR2 is turned on, a capacitance may be formed between the second auxiliary electrode E2 and the second active layer A2. As a result, when the second thin film transistor TR2 is turned on, the degree of increase in the current I_{DS} with respect to the voltage V_{GS} is small, in a range of the threshold voltage Vth. Accordingly, the second thin film transistor TR2 can have a large s-factor.

Therefore, the second thin film transistor TR2 according to one embodiment of the present disclosure may be used as a driving transistor dTR of the display apparatus 100.

The third thin film transistor TR3 may include a third auxiliary electrode E3, a third active layer A3, a third gate electrode G3, a third source electrode S3, and a third drain electrode D3.

Since the third auxiliary electrode E3 is connected to the third source electrode S3 and overlaps the third active layer A3, at the time when the third thin film transistor TR3 is turned on, a capacitance may be formed between the third auxiliary electrode E3 and the third active layer A3. As a result, when the third thin film transistor TR3 is turned on, the degree of increase in the current I_{DS} with respect to the voltage V_{GS} is small in a range of the threshold voltage Vth. Therefore, the third thin film transistor TR3 can have a large s-factor.

Therefore, the third thin film transistor TR3 according to one embodiment of the present disclosure may be used as a driving transistor dTR of the display apparatus 100.

Hereinafter, the s-factor is explained in more detail.

In order for a current driven display apparatus 100, for example, an organic light emitting display apparatus, to have excellent gray scale expression capability, it is advantageous that the s-factor of a driving transistor dTR, which drives the pixel of the organic light emitting display apparatus, is large.

The s-factor, which may be referred to as "sub-threshold swing", is obtained as the reciprocal value of the slope of the graph showing the change of the drain current I_{DS} with respect to the gate voltage V_{GS} of the thin film transistors TR1, TR2, TR3 in a range of the threshold voltage Vth. In addition, the gray scale of the pixels P1, P2 may be controlled by the magnitude of the drain-source current, and the magnitude of the drain-source current is controlled by the gate voltage.

As the s-factor increases, the change of the drain-source current I_{DS} with respect to the gate voltage in the threshold voltage Vth range becomes small or gradual. Accordingly, when the s-factor is larger, it becomes easier to control the magnitude of the drain-source current I_{DS} by controlling the gate voltage.

In addition, as the distance between the gate electrodes G1, G2, G3 and the active layers A1, A2, A3 increases, the electric field applied to the active layers A1, A2, A3 becomes weaker, resultingly the slope of the drain-source current I_{DS} with respect to the gate voltage V_{GS} decreases, and as a result, the s-factor increases.

According to one embodiment of the present disclosure, the second active layer A2 is disposed in the first concave part 125 formed in the buffer layer 120. As a result, the distance t2 between the second active layer A2 and the second gate electrode G2 is greater than the distance t3 between the third active layer A3 and the third gate electrode G3 (t2 > t3). As a result, when the same voltage is applied to the second gate electrode G2 and the third gate electrode G3, the intensity of the electric field applied to the second active layer A2 is smaller than the intensity of the electric field applied to the third active layer A3. As a result, the degree of increase in the current I_{DS} with respect to the voltage V_{GS} in the gate voltage Vth region of the second thin film transistor TR2 is smaller than the degree of increase in the current I_{DS} with respect to the voltage V_{GS} in the gate voltage Vth region of the third thin film transistor TR3.

Therefore, the second thin film transistor TR2 may have a larger s-factor than the third thin film transistor TR3.

The second thin film transistor TR2 having a larger s-factor than the third thin film transistor TR3 may be applied to pixels requiring more precise gray scale control.

According to one embodiment of the present disclosure, when implementing white light in an organic light emitting display, the luminance of green light occupies a large portion of the total luminance. For example, a display apparatus 100 according to one embodiment of the present disclosure may include a red pixel, a green pixel, and a blue pixel, and when the display apparatus 100 expresses white light, the luminance of green light may occupy about 70% of the total luminance, the luminance of red light may occupy about 23 to 24% of the total luminance, and the luminance of blue light may occupy about 6 to 7% of the total luminance. Therefore, in order to control the luminance and gradation of the display apparatus 100, it is necessary to precisely control the luminance of green light.

In order to precisely control the brightness of green light, according to one embodiment of the present disclosure, a second thin film transistor TR2 may be applied as a driving transistor dTR of a green pixel.

According to one embodiment of the present disclosure, the first pixel P1 may be a green pixel, and the second pixel P2 may be a non-green pixel. In detail, the first pixel P1 may emit green light, and the second pixel P2 may emit non-green light. For example, the second pixel P2 may emit red light or blue light.

The first pixel P1 that emits green light may include a first thin film transistor TR1 and a second thin film transistor TR2. The second thin film transistor TR2 may be connected to a first display element ED1. Here, the first display element ED1 may be a green organic light emitting element.

The second pixel P2 may include a first thin film transistor TR1 and a third thin film transistor TR3. The third thin film transistor TR3 may be connected to a second display element ED2. Here, the second display element ED2 may be, for example, a red organic light emitting element or a blue organic light emitting element.

According to one embodiment of the present disclosure, the second thin film transistor TR2 may have an s-factor of, for example, 0.3 or more. When the second thin film transistor TR2 has an s-factor of 0.3 or more, the gray scale of the first pixel P1, which is a green pixel, may be easily controlled. Meanwhile, when the s-factor of the second thin film transistor TR2 becomes excessively large, the power consumption of the display apparatus 100 increases. Considering this, the second thin film transistor TR2 according to one embodiment of the present disclosure may have an s-factor in the range of 0.3 to 0.5.

As described above, in one embodiment of the present disclosure, the configurations of the driving transistors dTR may be designed differently according to the colors of the pixels where the driving transistors dTR are equipped with, and thus the display characteristic of the display apparatus 100 can be improved.

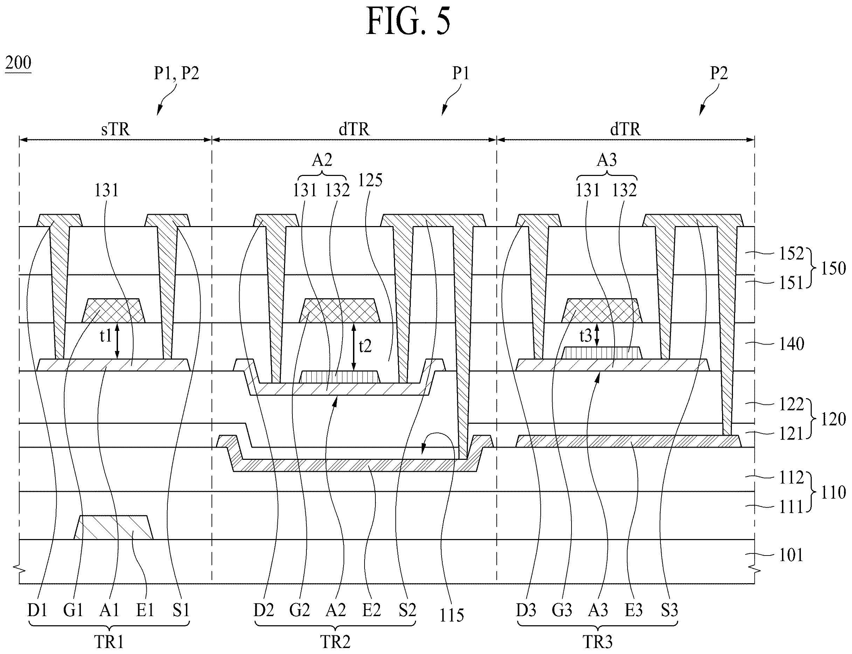

FIG. 5 is a cross-sectional view of thin film transistors TR1, TR2, TR3 included in pixels P1, P2 of a display apparatus 200 according to another embodiment of the present disclosure. Hereinafter, descriptions of components already described are omitted or simplified in order to avoid redundancy.

Referring to FIG. 5, the insulating layer 110 may have a second concave part 115. In addition, a second auxiliary electrode E2 may be disposed in the second concave part 115.

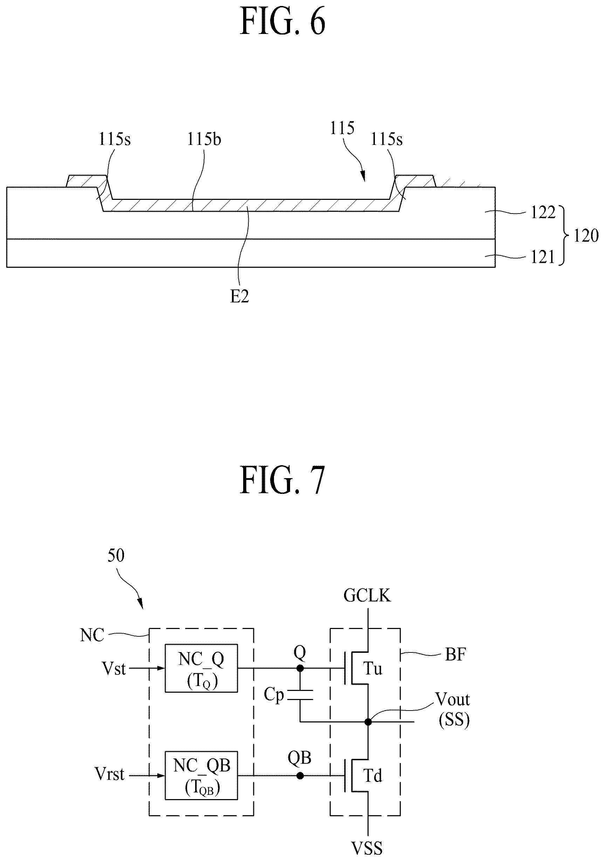

FIG. 6 is an enlarged cross-sectional view of the second concave part 115 of FIG. 5.

Referring to Fig. 6, the second concave part 115 may have a flat surface 115b and an inclined surface 115s. A portion of the second auxiliary electrode E1 may be disposed on the flat surface 115b of the second concave part 115, and another portion of the second auxiliary electrode E1 may be disposed on the inclined surface 115s of the second concave part 115.

As a portion of the second auxiliary electrode E1 is disposed on the inclined surface 115s of the second concave part 115, the second auxiliary electrode E1 can effectively protect the second active layer A2 from light incident from the side direction.

In addition, as the second concave part 115 is formed in the insulating layer 110, the distance t2 between the second active layer A2 and the second gate electrode G2 overlapping the second concave part 115 can increase.

FIG. 7 is a schematic circuit diagram of one embodiment of a shift register 50 included in a gate driver 20.

The display apparatus 100 according to one embodiment of the present disclosure may include a gate driver 20, and the gate driver 20 provides a scan signal SS to each of a first pixel P1 and a second pixel P2. The gate driver 20 may include a buffer transistor bTR that controls application of the scan signal SS and a switching transistor sTR that controls driving of the buffer transistor bTR.

In detail, a buffer transistor bTR and a switching transistor sTR may be disposed in a shift register 50 of the gate driver 20.

Referring to FIG. 7, the shift register 50 included in the gate driver 20 may include a pull-up node Q, a pull-down node QB, a node control unit NC, and a buffer unit BF.

The buffer unit BF is connected to the output terminal Vout and may include a pull-up transistor Tu, a pull-down transistor Td, and a capacitor Cp.

The pull-up transistor Tu may be turned on when the pull-up node Q is charged to a high gate voltage to output a gate-on signal of the gate shift clock (GCLK). For example, the gate-on signal of the gate shift clock (GCLK) may be a high voltage of the gate shift clock, but is not limited thereto.

The pull-down transistor Td may be turned on when the pull-down node QB is charged to a gate low voltage to output a gate-off signal (e.g., a low-potential voltage or a low-voltage power supply having a transistor-off voltage level).

According to one embodiment of the present disclosure, a pull-up transistor Tu and a pull-down transistor Td included in a buffer unit BF are referred to as buffer transistors bTR. The buffer transistors bTR control the application of scan signals SS to pixels P1, P2.

The capacitor Cp serves to maintain the gate high voltage supplied to the gate electrode (or pull-up node Q) of the pull-up transistor Tu for one frame. The capacitor Cp may be placed between the gate electrode and the first electrode of the pull-up transistor Tu. For example, the first electrode of the pull-up transistor Tu may be either a source electrode or a drain electrode. For example, the capacitor Cp may be a parasitic capacitance between the gate electrode and the first electrode of the pull-up transistor Tu, but is not limited thereto.

The node control unit NC controls charging and discharging of the pull-up node Q and the pull-down node QB. The node control unit NC may include a pull-up node control unit NC_Q for controlling charging and discharging of the pull-up node Q and a pull-down node control unit NC_QB for controlling charging and discharging of the pull-down node QB. The pull-up node control unit NC_Q may include at least one transistor TQ for controlling the voltage (or charging and discharging voltage) of the pull-up node Q. The pull-down node control unit NC_QB may include at least one transistor TQB for controlling the voltage (or charging and discharging voltage) of the pull-down node QB.

The output of a gate-on signal or a low-potential voltage (or gate-off signal) SS output to an output terminal Vout may be stably controlled by a node control unit NC. In detail, the node control unit NC discharges a pull-down node QB to a gate low voltage (or low-potential voltage) when a pull-up node Q is charged to a gate high voltage, and discharges a pull-up node Q to a gate low voltage (or low-potential voltage) when a pull-down node QB is charged to a gate high voltage.

Accordingly, when a gate start signal Vst is applied, the pull-up node Q is charged with a gate high voltage by the operation of a plurality of transistors TQ, TQB provided in the node control unit NC, thereby turning on the pull-up transistor Tu, and at the same time, the voltage of the pull-down node QB is discharged to a gate low voltage, thereby turning off the pull-down transistor Td, so that the gate on signal of the gate shift clock (GCLK) may be output to the output terminal Vout through the turned-on pull-up transistor Tu.

In addition, when a gate reset signal Vrst is applied, the voltage of the pull-up node Q is discharged to a gate low voltage by the operation of a plurality of transistors TQ, TQB provided in the node control unit NC, so that the pull-up transistor Tu is turned off, and at the same time, the gate high voltage is charged in the pull-down node QB, so that the pull-down transistor Td is turned on, so that the low-potential voltage VSS may be output to the output terminal Vout through the turned-on pull-down transistor Td.

According to one embodiment of the present disclosure, a plurality of transistors TQ, TQB provided in a node control unit NC are referred to as switching transistors. The switching transistor of the gate driver 20 may be said to control the operation of the buffer transistor bTR. The switching transistor sTR of the gate driver 20 can include a first thin film transistor TR1. The switching transistor sTR of the gate driver 20 may have the same structure with the first thin film transistor TR1 of FIG. 3 and FIG. 5.

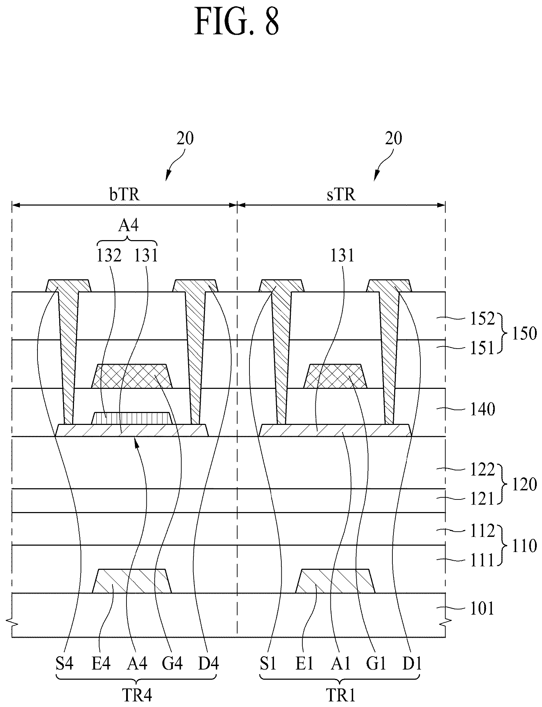

FIG. 8 is a cross-sectional view of thin film transistors bTR, sTR of the gate driver 20.

The thin film transistors bTR, sTR of FIG. 8 may be disposed in the shift register 50 of the gate driver 20.

According to one embodiment of the present disclosure, the switching transistor sTR disposed in the gate driver 20 may have, for example, the same structure as the first thin film transistor TR1 of FIG. 8. According to one embodiment of the present disclosure, the buffer transistor bTR disposed in the gate driver 20 may have, for example, the same structure as the fourth thin film transistor TR4 of FIG. 8.

The first thin film transistor TR1 of FIG. 8 has the same structure as the first thin film transistor TR1 of FIG. 3, and in order to avoid redundancy, a detailed description of the switching transistor sTR of the gate driver 20 having the same structure as the first thin film transistor TR1 is omitted.

Referring to FIG. 8, the fourth thin film transistor TR4, which is a buffer transistor bTR, includes a fourth auxiliary electrode E4 on a substrate 101, a fourth active layer A4 on the fourth auxiliary electrode E4, and a fourth gate electrode G4 on the fourth active layer A4.

The fourth auxiliary electrode E4 is electrically connected to the fourth gate electrode G4. The same voltage as that of the fourth gate electrode G4 may be applied to the fourth auxiliary electrode E4. The fourth auxiliary electrode E4 overlaps the fourth active layer A4 and can function as a gate electrode for the fourth active layer A4. Therefore, according to one embodiment of the present disclosure, the fourth thin film transistor TR4 may have a double gate structure in which gate electrodes are disposed on both the upper and lower sides of the fourth active layer A4.

According to one embodiment of the present disclosure, a first thin film transistor TR1 having a double gate structure can have excellent on-off characteristic.

In addition, the fourth active layer A4 includes a first oxide semiconductor layer 131 and a second oxide semiconductor layer 132 on the first oxide semiconductor layer 131. The first oxide semiconductor layer 131 and the second oxide semiconductor layer 132 have already been described.

The first oxide semiconductor layer 131 can have excellent stability, and the second oxide semiconductor layer 132 can have excellent current characteristic. Therefore, the fourth active layer A4 can have excellent stability while having excellent current characteristic.

Therefore, the buffer transistor bTR according to one embodiment of the present disclosure has excellent switching characteristic, excellent driving stability, and can have excellent current characteristic.

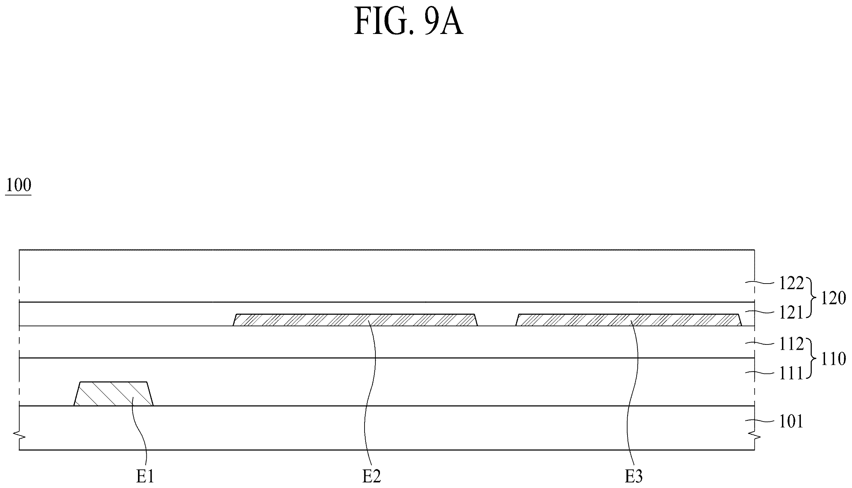

Hereinafter, with reference to FIG. 9A to FIG. 9G, a manufacturing method a display apparatus 100 according to one embodiment of the present disclosure will be described.

FIG. 9A to FIG. 9G are schematic cross-sectional views for explaining a manufacturing process of a display apparatus 100 according to one embodiment of the present disclosure.

Referring to FIG. 9A, for manufacturing a display apparatus 100, a first auxiliary electrode E1 is formed on a substrate 10. In addition, an insulating layer 110 is formed on the first auxiliary electrode E1. The insulating layer 110 may include a first insulating layer 111 and a second insulating layer 112.

Referring to FIG. 9A, a second auxiliary electrode E2 and a third auxiliary electrode E3 may be formed on the insulating layer 110.

Additionally, a buffer layer 120 may be formed on the second auxiliary electrode E2 and the third auxiliary electrode E3. The buffer layer 120 may include a first buffer layer 121 and a second buffer layer 122.

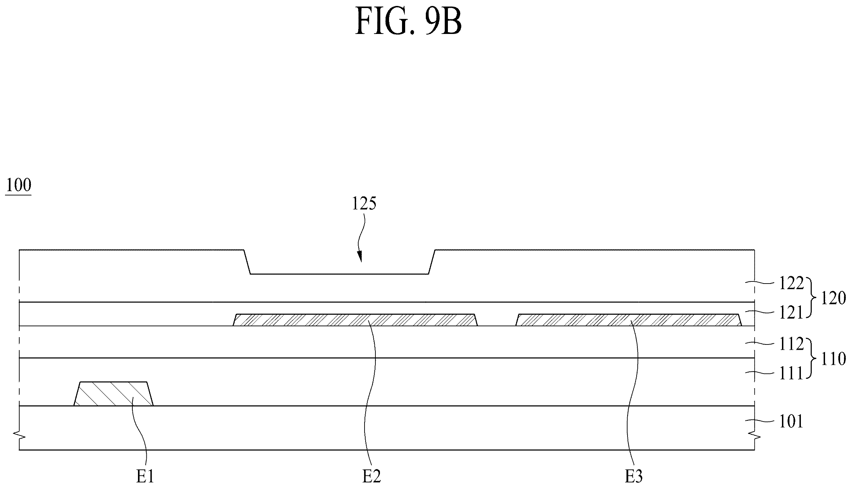

Referring to FIG. 9B, a portion of the buffer layer 120 may be removed to create a first concave part 125. The first concave part 125 may be formed in the buffer layer 120. As described above, forming the buffer layer 120 may include forming the first concave part 125.

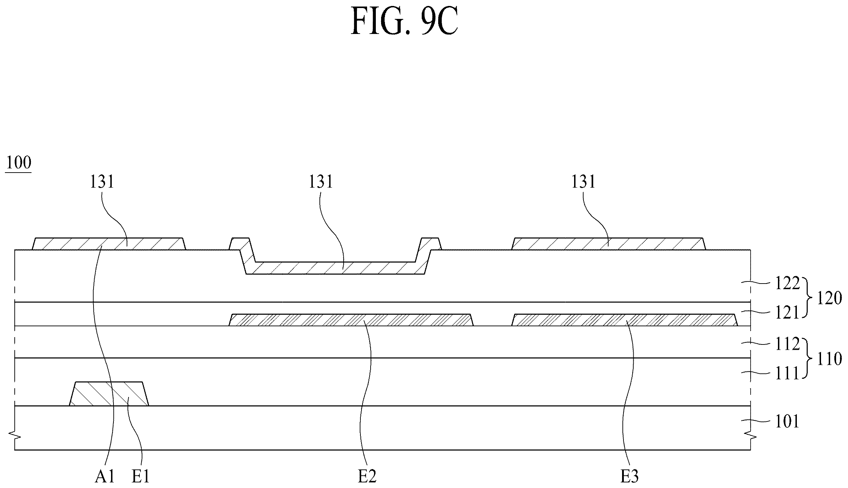

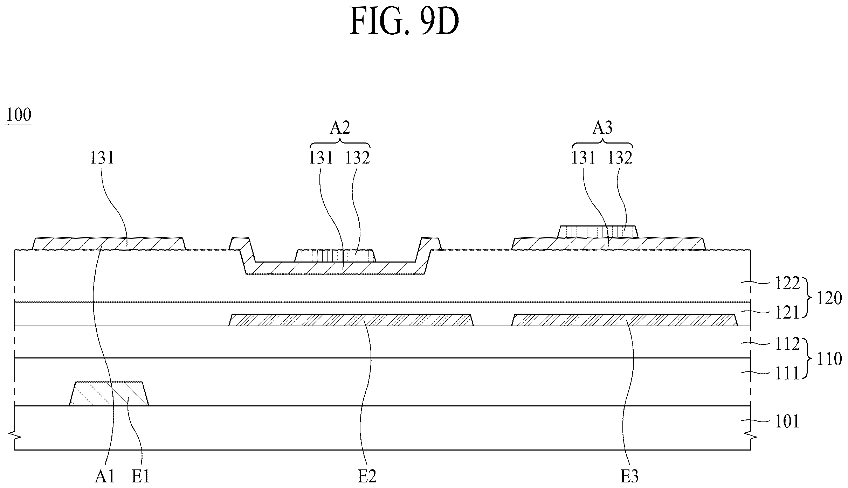

Referring to FIG. 9C and FIG. 9D, a first active layer A1, a second active layer A2, and a third active layer A3 are formed on a buffer layer 120. The second active layer A2 may be formed to be disposed in the first concave part 125.

In detail, referring to FIG. 9C, a first oxide semiconductor layer 131 is formed on a buffer layer 120. A first active layer A1 may be formed by the first oxide semiconductor layer 131 formed at a position overlapping the first auxiliary electrode E1.

Referring to FIG. 9D, a second oxide semiconductor layer 132 is formed on the first oxide semiconductor layer 131 overlapping the second auxiliary electrode E2, and a second oxide semiconductor layer 132 is formed on the first oxide semiconductor layer 131 overlapping the third auxiliary electrode E3.

A second active layer A2 may be formed by a first oxide semiconductor layer 131 and a second oxide semiconductor layer 132 formed at a region overlapping the second auxiliary electrode E2.

A third active layer A3 may be formed by a first oxide semiconductor layer 131 and a second oxide semiconductor layer 132 formed at a region overlapping the third auxiliary electrode E3.

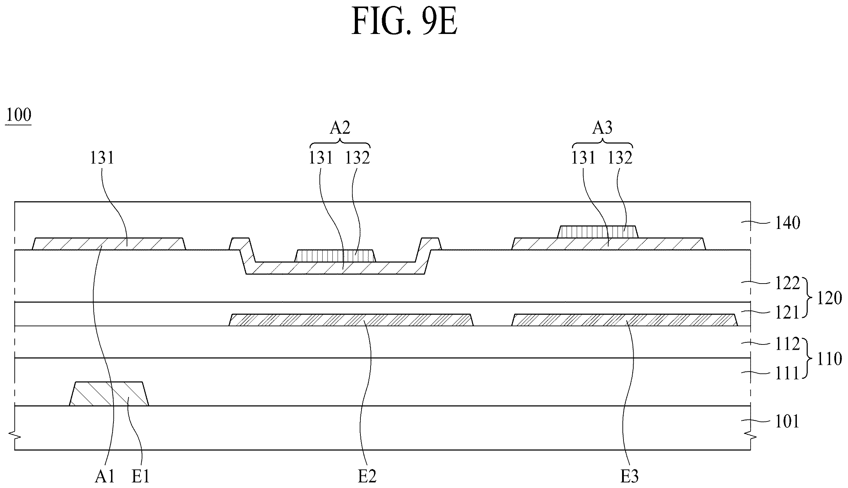

Referring to FIG. 9E, a gate insulating film 140 is formed on the first active layer A1, the second active layer A2, and the third active layer A3.

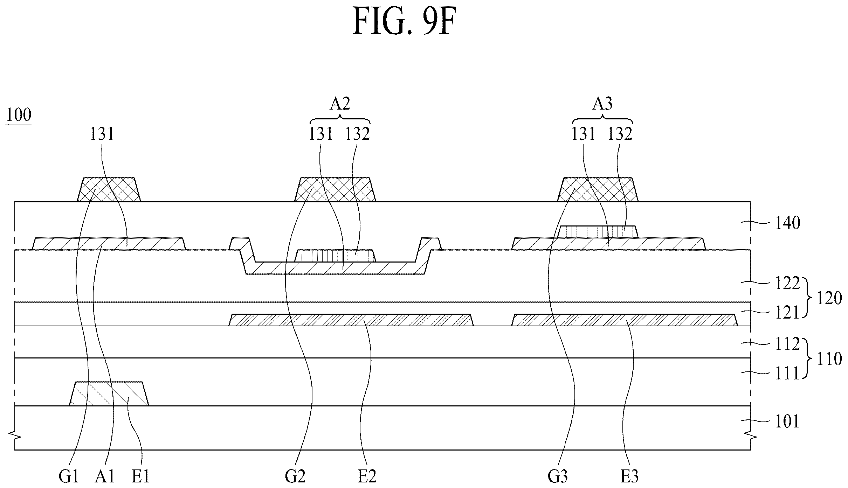

Referring to FIG. 9F, a first gate electrode A1, a second gate electrode A2, and a third gate electrode A3 are formed on a gate insulating film 140.

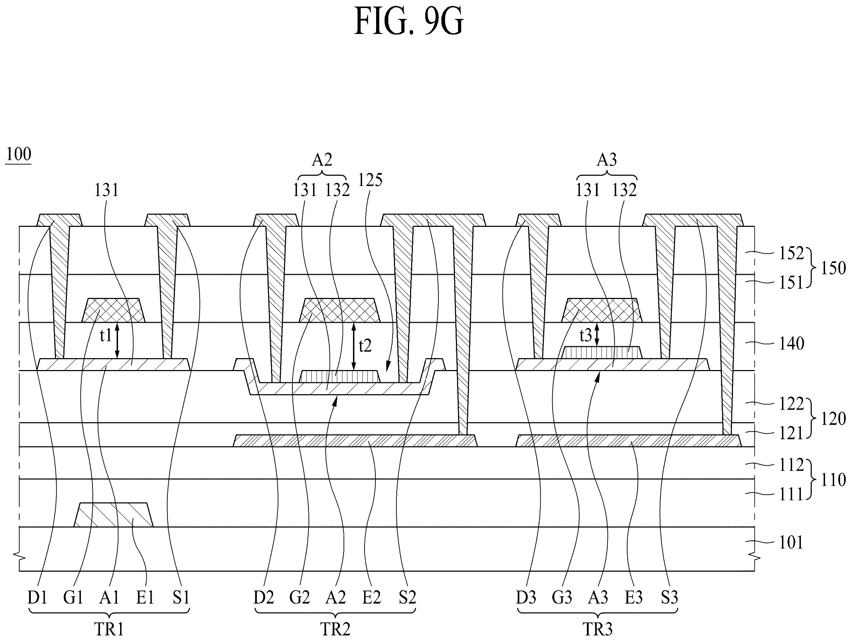

Referring to FIG. 9g, an interlayer insulating film 150 is formed on the first gate electrode A1, the second gate electrode A2, and the third gate electrode A3. The interlayer insulating film 150 may include a first insulating film 151 and a second insulating film 152.

Additionally, source electrodes S1, S2, S3 and drain electrodes D1, D2, D3 may be formed on the interlayer insulating film 150.

By the method including the above process, a display 100 according to one embodiment of the present disclosure may be made.

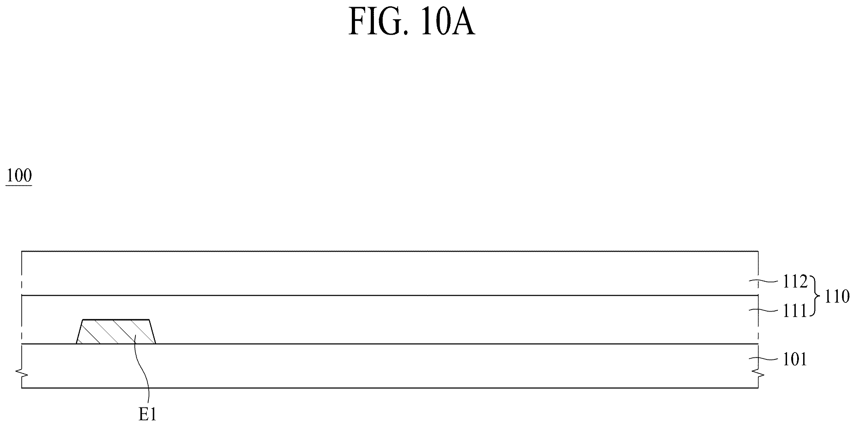

FIG. 10A to FIG. 10H are schematic cross-sectional views illustrating a manufacturing process of a display apparatus 200 according to another embodiment of the present disclosure.

Referring to FIG. 10A, for manufacturing a display apparatus 100, a first auxiliary electrode E1 is formed on a substrate 10. In addition, an insulating layer 110 is formed on the first auxiliary electrode E1. The insulating layer 110 may include a first insulating layer 111 and a second insulating layer 112.

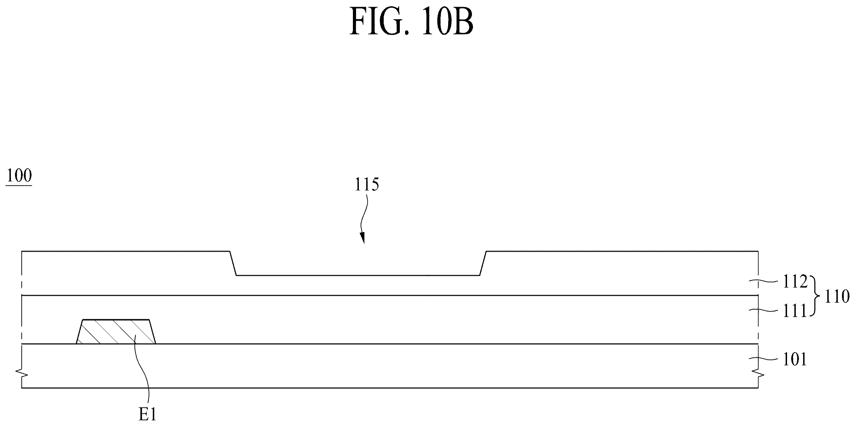

Referring to FIG. 10B, a second concave part 115 is formed in the insulating layer 110. The second concave part 115 may be created by removing a portion of the insulating layer 110.

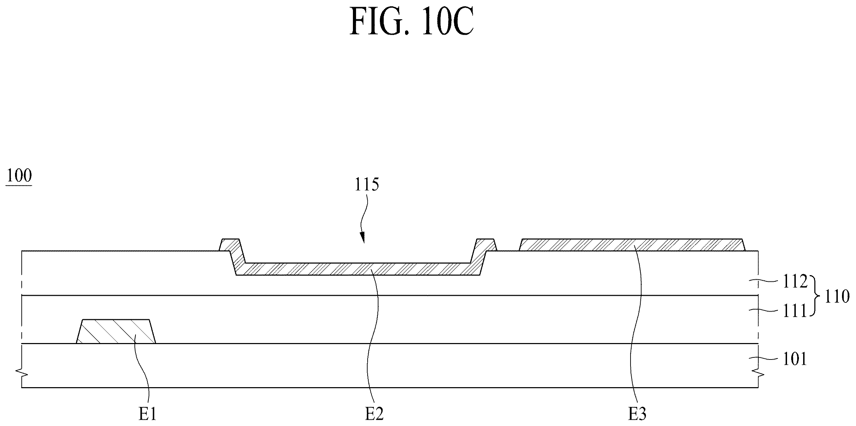

Referring to FIG. 10C, a second auxiliary electrode E2 and a third auxiliary electrode E3 are formed on the insulating layer 110. The second auxiliary electrode E2 may be formed on the second concave part 115.

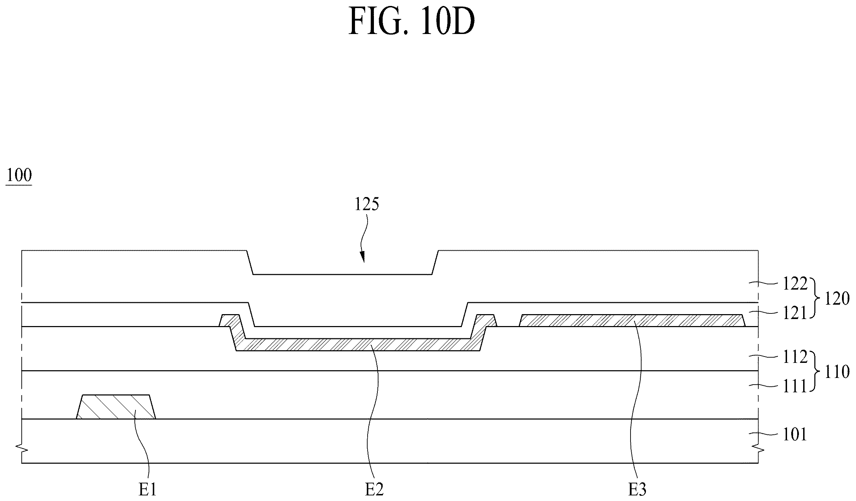

Referring to FIG. 10D, a buffer layer 120 is formed on the second auxiliary electrode E2 and the third auxiliary electrode E3. The buffer layer 120 may include a first buffer layer 121 and a second buffer layer 122.

Also, referring to FIG. 10D, a first concave part 125 may be formed in the buffer layer 120. The first concave part 125 may be formed on the second concave part 115.

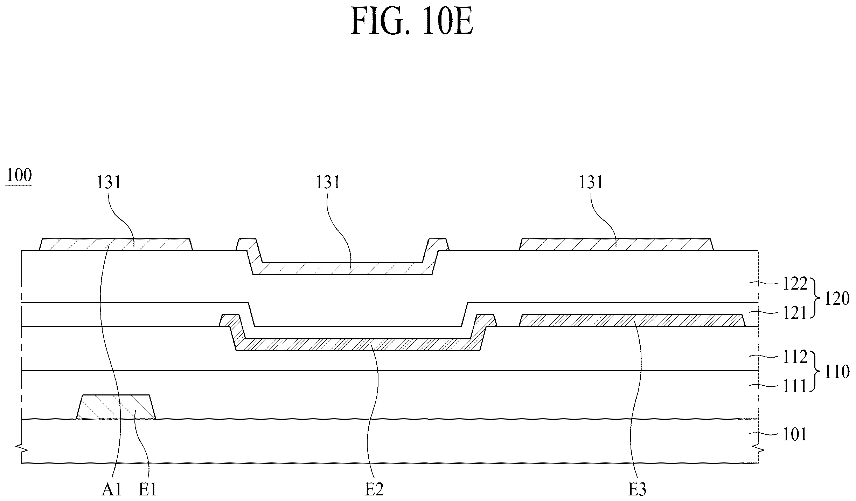

Referring to FIG. 10E, a first oxide semiconductor layer 131 is formed on a buffer layer 120. A first active layer A1 may be formed by the first oxide semiconductor layer 131 formed at a position overlapping the first auxiliary electrode E1.

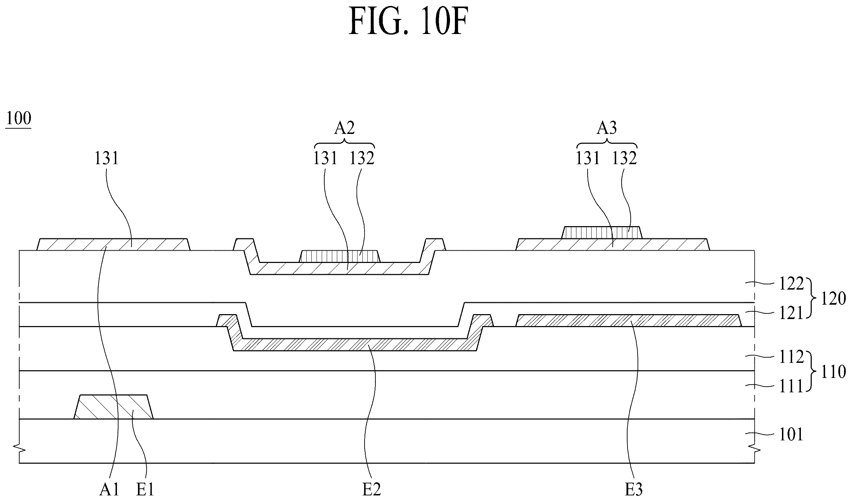

Referring to FIG. 10F, a second oxide semiconductor layer 132 is formed on a first oxide semiconductor layer 131 overlapping a second auxiliary electrode E2, and a second oxide semiconductor layer 132 is formed on a first oxide semiconductor layer 131 overlapping a third auxiliary electrode E3.

A second active layer A2 may be formed by a first oxide semiconductor layer 131 and a second oxide semiconductor layer 132 formed at a region overlapping the second auxiliary electrode E2.

A third active layer A3 may be formed by a first oxide semiconductor layer 131 and a second oxide semiconductor layer 132 formed at a region overlapping the third auxiliary electrode E3.

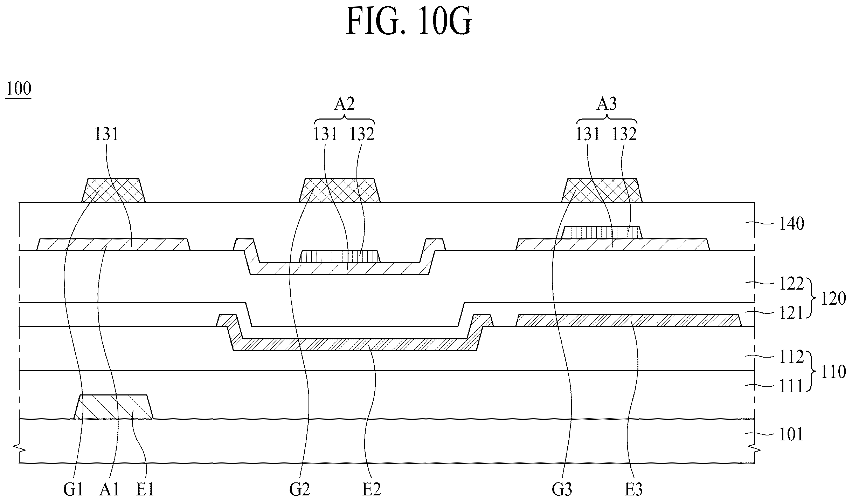

Referring to FIG. 10G, a gate insulating film 140 is formed on the first active layer A1, the second active layer A2, and the third active layer A3, and a first gate electrode A1, a second gate electrode A2, and a third gate electrode A3 are formed on the gate insulating film 140.

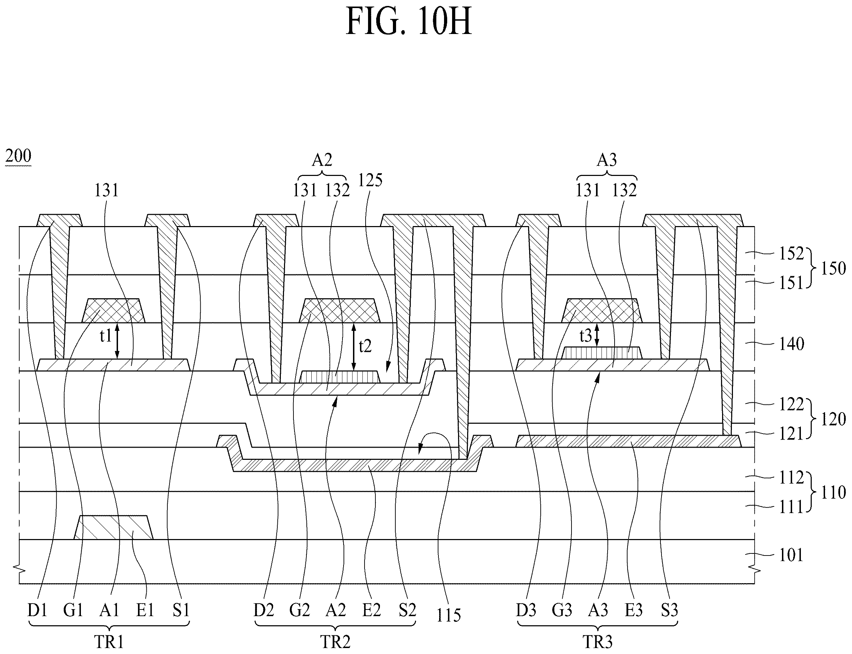

Referring to FIG. 10H, an interlayer insulating film 150 may be formed on the first gate electrode A1, the second gate electrode A2, and the third gate electrode A3, and a source electrode S1, S2, S3 and a drain electrode D1, D2, D3 may be formed on the interlayer insulating film 150.

By the method including the above process, a display 100 according to one embodiment of the present disclosure may be made.

The present disclosure described above is not limited to the above-described embodiments and the attached drawings, and it will be apparent to a person skilled in the art to which the present disclosure pertains that various substitutions, modifications, and changes are possible within a scope that does not depart from the technical details of the present disclosure.

A display apparatus according to one embodiment of the present disclosure includes both a thin film transistor having excellent switching characteristic and a thin film transistor having a large s-factor, so that the response speed is fast and gray scale expression is easy.

According to one embodiment of the present disclosure, since it includes a plurality of thin film transistors configured to have different driving characteristic depending on the pixel, the driving characteristic of the pixel may be controlled for each color. Therefore, according to one embodiment of the present disclosure, the thin film transistor may be designed to enable precise gray scale expression in pixels that require precise gray scale expression, and the structure of the thin film transistor may be designed more simply in pixels that do not require precise gray scale expression. In addition, thin film transistors having high mobility characteristic may be disposed in pixels that require high mobility.

According to one embodiment of the present disclosure, a switching transistor may exhibit excellent stability. Accordingly, a short channel may be implemented, and even when implemented with a short channel, threshold voltage shift is suppressed and a stable threshold voltage may be secured.

According to one embodiment of the present disclosure, a switching transistor applied to a display apparatus can have a stable threshold voltage while having a short channel length, a driving transistor can have excellent gray scale expression characteristic by having a large s-factor, and can have excellent mobility by including a high-mobility semiconductor material.

The following numbered examples pertain to embodiments of the present disclosure:
Example 1: A display apparatus comprising: a substrate; a plurality of first thin film transistors, a plurality of second thin film transistors, and a plurality of third thin film transistors on the substrate, wherein each of the plurality of first thin film transistors includes a first active layer and a first gate electrode on the first active layer, wherein each of the plurality of second thin film transistors includes a second active layer and a second gate electrode on the second active layer, wherein each of the plurality of third thin film transistors includes a third active layer and a third gate electrode on the third active layer, wherein a distance between the second active layer and the second gate electrode is greater than a distance between the third active layer and the third gate electrode, wherein each of the plurality of first thin film transistors further includes a first auxiliary electrode between the substrate and the first active layer, and wherein the first auxiliary electrode is electrically connected to the first gate electrode.
Example 2: The display apparatus of Example 1, wherein a distance between the first active layer and the first gate electrode is smaller than the distance between the second active layer and the second gate electrode.
Example 3: The display apparatus of Example 1 or 2, wherein each of the second active layer and the third active layer includes: a first oxide semiconductor layer; and a second oxide semiconductor layer on the first oxide semiconductor layer.
Example 4: The display apparatus of Example 3, wherein the second oxide semiconductor layer has a higher mobility than the first oxide semiconductor layer.
Example 5: The display apparatus of Example 4, wherein the first oxide semiconductor layer has a mobility of 14 cm²/V·s or less, and the second oxide semiconductor layer has a mobility of 15 cm²/V·s or more.
Example 6: The display apparatus of any of Examples 3 to 5, wherein the first active layer is formed of the same material as the first oxide semiconductor layer.
Example 7: The display apparatus of any of Examples 1 to 6, further comprising: a gate insulating film disposed between the first active layer and the first gate electrode, between the second active layer and the second gate electrode, and between the third active layer and the third gate electrode, wherein a thickness of the gate insulating film between the first active layer and the first gate electrode is defined as t1, a thickness of the gate insulating film between the second active layer and the second gate electrode is defined as t2, a thickness of the gate insulating film between the third active layer and the third gate electrode is defined as t3, and wherein "t2 > t1" and "t2 > t3" is satisfied.
Example 8: The display apparatus of any of Examples 1 to 7, further comprising: a buffer layer on the substrate, wherein the buffer layer includes a first concave part, and the second active layer is disposed in the first concave part.
Example 9: The display apparatus of Example 8, wherein the first concave part includes a flat surface and an inclined surface, and wherein a portion of the second active layer is disposed on the flat surface and another portion of the second active layer is disposed on the inclined surface.
Example 10: The display apparatus of Example 9, wherein the second active layer includes a first oxide semiconductor layer and a second oxide semiconductor layer on the first oxide semiconductor layer, and wherein at least a portion of the first oxide semiconductor layer is disposed on the inclined surface.
Example 11: The display apparatus of any of Examples 8 to 10, further comprising: an insulating layer between the substrate and the buffer layer; and a second auxiliary electrode and a third auxiliary electrode on the insulating layer, wherein the second auxiliary electrode overlaps the second active layer, and wherein the third auxiliary electrode is spaced apart from the second auxiliary electrode and overlaps the third active layer.
Example 12: The display apparatus of Example 11, wherein the second auxiliary electrode has a light shielding property and is electrically connected to the second active layer, and wherein the third auxiliary electrode has a light shielding property and is electrically connected to the third active layer.
Example 13: The display apparatus of Example 12, wherein the insulating layer includes a second concave part, and wherein the second auxiliary electrode is disposed in the second concave part.
Example 14: The display apparatus of Example 13, wherein the second concave part includes a flat surface and an inclined surface, and wherein a portion of the second auxiliary electrode is disposed on the flat surface and another portion of the second auxiliary electrode is disposed on the inclined surface.
Example 15: The display apparatus of any of Examples 11 to 14, wherein the first auxiliary electrode is disposed between the substrate and the insulating layer.
Example 16: The display apparatus of any of Examples 1 to 15, wherein the second thin film transistors have a greater s-factor than the third thin film transistors.
Example 17: The display apparatus of any of Examples 1 to 16, further comprising: a first pixel and a second pixel on the substrate, wherein the first pixel includes: one of the plurality of first thin film transistors; one of the plurality of second thin film transistors; and a first display element connected to the one of the plurality of second thin film transistors, and wherein the second pixel includes: another one of the plurality of first thin film transistors; one of the plurality of third thin film transistors; and a second display element connected to the one of the plurality of third thin film transistors.
Example 18: The display apparatus of Example 17, wherein the first pixel emits green light, and wherein the second pixel emits light of a color other than green.
Example 19: The display apparatus of Example 17 or 18, further comprising: a gate driver for providing a scan signal to each of the first pixel and the second pixel, wherein the gate driver includes a buffer transistor for controlling application of the scan signal and a switching transistor for controlling operation of the buffer transistor, and wherein the switching transistor includes yet another of the plurality of first thin film transistors.
Example 20: The display apparatus of Example 19, wherein the buffer transistor includes: a fourth auxiliary electrode on the substrate; a fourth active layer on the fourth auxiliary electrode; and a fourth gate electrode on the fourth active layer, wherein the fourth active layer includes: a first oxide semiconductor layer; and a second oxide semiconductor layer on the first oxide semiconductor layer, and wherein the fourth auxiliary electrode is electrically connected to the fourth gate electrode.
Example 21: A manufacturing method of a display apparatus, comprising: forming a first auxiliary electrode on a substrate; forming a buffer layer on the first auxiliary electrode; forming a first active layer, a second active layer, and a third active layer on the buffer layer; forming a gate insulating film on the first active layer, a second active layer, and a third active layer; and forming a first gate electrode, a second gate electrode, and a third gate electrode on the gate insulating film, wherein forming the buffer layer includes forming a first concave part, wherein the second active layer is formed to be disposed in the first concave part, and wherein the first auxiliary electrode is electrically connected to the first gate electrode.
Example 22: The manufacturing method of a display apparatus of Example 21, further comprising: forming an insulating layer on the substrate before forming the buffer layer; and forming a second auxiliary electrode and a third auxiliary electrode on the insulating layer, wherein forming the insulating layer includes forming a second concave part, and wherein the second auxiliary electrode is formed in the second concave part.

## Claims

1. A display apparatus (100, 200) comprising:
a substrate (101);
a plurality of first thin film transistors (TR1), a plurality of second thin film transistors (TR2), and a plurality of third thin film transistors (TR3) on the substrate (101),
wherein each of the plurality of first thin film transistors (TR1) includes a first active layer (A1) and a first gate electrode (G1) on the first active layer (A1),
wherein each of the plurality of second thin film transistors (TR2) includes a second active layer (A2) and a second gate electrode (G2) on the second active layer (A2),
wherein each of the plurality of third thin film transistors (TR3) includes a third active layer (A3) and a third gate electrode (G3) on the third active layer (A3),
wherein a distance between the second active layer (A2) and the second gate electrode (G2) is greater than a distance between the third active layer (A3) and the third gate electrode (G3),
wherein each of the plurality of first thin film transistors (TR1) further includes a first auxiliary electrode (E1) between the substrate (101) and the first active layer (A1), and
wherein the first auxiliary electrode (E1) is electrically connected to the first gate electrode (G1).

2. The display apparatus (100, 200) of claim 1,
wherein a distance between the first active layer (A1) and the first gate electrode (G1) is smaller than the distance between the second active layer (A2) and the second gate electrode (G2).

3. The display apparatus (100, 200) of claim 1 or 2,
wherein each of the second active layer (A2) and the third active layer (A3) includes:
a first oxide semiconductor layer (131); and
a second oxide semiconductor layer (132) on the first oxide semiconductor layer (131).

4. The display apparatus (100, 200) of claim 3,
wherein the second oxide semiconductor (132) layer has a higher mobility than the first oxide semiconductor layer (131),
wherein preferably:
the first oxide semiconductor (131) layer has a mobility of 14 cm²/V·s or less, and
the second oxide semiconductor layer (132) has a mobility of 15 cm²/V·s or more.

5. The display apparatus (100, 200) of claim 3 or 4,
wherein the first active layer (A1) is formed of the same material as the first oxide semiconductor layer (131).

6. The display apparatus (100, 200) of any of claims 1 to 5, further comprising:
a gate insulating film (140) disposed between the first active layer (A1) and the first gate electrode (G1), between the second active layer (A2) and the second gate electrode (G2), and between the third active layer (A3) and the third gate electrode (G3),
wherein a thickness of the gate insulating film (140) between the first active layer (A1) and the first gate electrode (G1) is defined as t1,
a thickness of the gate insulating film (140) between the second active layer (A2) and the second gate electrode (G2) is defined as t2,
a thickness of the gate insulating film (140) between the third active layer (A3) and the third gate electrode (G3) is defined as t3, and
wherein "t2 > t1" and "t2 > t3" is satisfied.

7. The display apparatus (100, 200) of any of claims 1 to 6, further comprising:
a buffer layer (120) on the substrate (101),
wherein the buffer layer (120) includes a first concave part (125), and
the second active layer (A2) is disposed in the first concave part (125).

8. The display apparatus (100, 200) of claim 7,
wherein the first concave part (125) includes a flat surface and an inclined surface, and
wherein a portion of the second active layer (A2) is disposed on the flat surface and another portion of the second active layer (A2) is disposed on the inclined surface,
wherein preferably:
the second active layer (A2) includes a first oxide semiconductor layer (131) and a second oxide semiconductor layer (132) on the first oxide semiconductor layer (131), and
at least a portion of the first oxide semiconductor layer (131) is disposed on the inclined surface.

9. The display apparatus (100, 200) of claim 7 or 8, further comprising:
an insulating layer (110) between the substrate (101) and the buffer layer (120); and
a second auxiliary electrode (E2) and a third auxiliary electrode (E3) on the insulating layer (110),
wherein the second auxiliary electrode (E2) overlaps the second active layer (A2), and
wherein the third auxiliary electrode (E3) is spaced apart from the second auxiliary electrode (E2) and overlaps the third active layer (A3),
wherein preferably:
the first auxiliary electrode (E1) is disposed between the substrate (101) and the insulating layer (110).

10. The display apparatus (100, 200) of claim 9,
wherein the second auxiliary electrode (E2) has a light shielding property and is electrically connected to the second active layer (A2), and
wherein the third auxiliary electrode (E3) has a light shielding property and is electrically connected to the third active layer (A3).

11. The display apparatus (100, 200) of claim 10,
wherein the insulating layer (120) includes a second concave part (115), and wherein the second auxiliary electrode (E2) is disposed in the second concave part (115),
wherein preferably:
the second concave part (115) includes a flat surface and an inclined surface, and
a portion of the second auxiliary electrode (E2) is disposed on the flat surface and another portion of the second auxiliary electrode (E2) is disposed on the inclined surface.

12. The display apparatus (100, 200) of any of claims 1 to 11,
wherein the second thin film transistors (TR2) have a greater s-factor than the third thin film transistors (TR3).

13. The display apparatus (100, 200) of any of claims 1 to 12, further comprising:
a first pixel (P1) and a second pixel on the substrate (101),
wherein the first pixel (P1) includes:
one of the plurality of first thin film transistors (TR1);
one of the plurality of second thin film transistors (TR2); and
a first display element (ED1) connected to the one of the plurality of second thin film transistors (TR2), and
wherein the second pixel (P2) includes:
another one of the plurality of first thin film transistors (TR1);
one of the plurality of third thin film transistors (TR3); and
a second display element (ED2) connected to the one of the plurality of third thin film transistors (TR3),
wherein preferably:
the first pixel (P1) emits green light, and
the second pixel (P2) emits light of a color other than green.

14. The display apparatus (100, 200) of claim 13 further comprising:
a gate driver (20) for providing a scan signal (SS) to each of the first pixel (P1) and the second pixel (P2),
wherein the gate driver (20) includes a buffer transistor (bTR) for controlling application of the scan signal (SS) and a switching transistor (sTR) for controlling operation of the buffer transistor (bTR), and
wherein the switching transistor (sTR) includes yet another one of the plurality of first thin film transistors (TR1),
wherein preferably:
the buffer transistor (bTR) includes:
a fourth auxiliary electrode (E4) on the substrate (101);
a fourth active layer (A4) on the fourth auxiliary electrode (E4); and
a fourth gate electrode (G4) on the fourth active layer (A4),
wherein the fourth active layer (A4) includes:
a first oxide semiconductor layer (131); and
a second oxide semiconductor layer (132) on the first oxide semiconductor layer (131), and
wherein the fourth auxiliary electrode (E4) is electrically connected to the fourth gate electrode (G4).

15. A manufacturing method of a display apparatus (100, 200), comprising:
forming a first auxiliary electrode (E1) on a substrate (101);
forming a buffer layer (120) on the first auxiliary electrode (E1);
forming a first active layer (A1), a second active layer (A2), and a third active layer (A3) on the buffer layer (120);
forming a gate insulating film (140) on the first active layer (A1), the second active layer (A2), and the third active layer (A3); and
forming a first gate electrode (G1), a second gate electrode (G2), and a third gate electrode (G3) on the gate insulating film (140),
wherein forming the buffer layer (120) includes forming a first concave part (125),
wherein the second active layer (A2) is formed to be disposed in the first concave part (125), and
wherein the first auxiliary electrode (E1) is electrically connected to the first gate electrode (G1),
the manufacturing method, preferably, further comprising:
forming an insulating layer (110) on the substrate (101) before forming the buffer layer (120); and
forming a second auxiliary electrode (E2) and a third auxiliary electrode (E3) on the insulating layer (110),
wherein forming the insulating layer (110) includes forming a second concave part (115), and
wherein the second auxiliary electrode (E2) is formed in the second concave part (115).
